(19) Europäisches Patentamt
European Patent Office
Office européen des brevets

(11) **EP 4 617 682 A1**

(12) **EUROPEAN PATENT APPLICATION**

(43) Date of publication:
**17.09.2025 Bulletin 2025/38**

(21) Application number: **24163650.5**

(22) Date of filing: **14.03.2024**

(51) International Patent Classification (IPC):
**G01R 19/25** $^{(2006.01)}$     **G01R 31/08** $^{(2020.01)}$

(52) Cooperative Patent Classification (CPC):
**G01R 19/2513**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Hitachi Energy Ltd**
**8050 Zürich (CH)**

(72) Inventors:
• **Bengtsson, Tord**
  **723 49 VÄSTERÅS, (SE)**
• **Abeywickrama, Nilanga**
  **723 51 Västerås (SE)**
• **Ghosh, Riddhi**
  **72241 Vasteras (SE)**
• **Slomski, Jan**
  **72341 Västerås (SE)**

(74) Representative: **AWA Sweden AB**
**Box 45086**
**104 30 Stockholm (SE)**

(54) **METHOD AND DEVICE FOR DETECTING POWER LINE FAULTS**

(57) There is disclosed herein a method for monitoring a power line, a device for performing the method, and a power transmission system comprising such a device. The method comprises obtaining a signal from the power line, comprising real-time information corresponding to the current and/or voltage on the power line at a monitoring location, decomposing the signal into one or more frequency bands, and monitoring each frequency band for an indication of a fault on the power line. According to such a method, fast transients arising from faults on the power can be rapidly identified, as part of a fault response trigger and the fault location can be determined without compromising accuracy of fault location, while allowing for a low usage of computational memory and/or processing.

Fig. 5

## Description

### Technical Field

The present disclosure relates to methods for detecting faults on a power line of a power transmission network, a device for implementing the methods, and a power transmission network comprising such a device.

### Background

After a fault on an overhead transmission line or underground cable, time to restoration of power is greatly dependent on the accurate localization of the fault before dispatching repair teams. Traditional impedance estimation-based fault locating functions available in numerical protection relays can provide location accuracy with a resolution of kilometers, while recently developed traveling wave-based (TW) fault location has the potential for accuracy of hundreds of meters, or better than two tower distances, thus allowing repair teams to quickly reach the fault to start remedial actions.

Fault location may be based on single- or double-end methods, wherein the fault location is determined based on timestamps for direct and/or reflected wavefronts, the wave speed, and line length such that the difference in the two timestamps can be used to determine the location of the fault on the power line. Hence, any errors in timestamps can affect the location accuracy.

Therefore, to accurately determine fault locations, it is useful to accurately determine the timestamps of the direct and/or reflected wavefronts. To determine these timestamps, it is useful to detect and/or record the waveforms reliably, with no or few wavefronts going undetected. In other words, if and when a fault occurs, a fault locating system should be able to identify and preferably record the waveform so that a traveling wave-based fault localization can be implemented, either online or offline.

### Summary

Aspects of the present disclosure relate to a method for detecting fault signals on a power line, which can be implemented by an embedded system on an acquisition board (or similar device) for installing directly onto a power line.

While recording the travelling wave from a fault is important for location of the fault, it can be difficult with conventional means to detect the occurrence of faults based on the incidence of a travelling wave at the acquisition board. The travelling wave may manifest as a 'fast transient' signal that precedes the fault current by a number of milliseconds.

Therefore, conventional systems may use 'level-based' detection of faults, whereby a certain current level is set as a threshold such that, when the fault current causes the current from the power line to exceed the set level, it is determined that a fault has occurred on the power line. The data recorded from the power line up until the detection is then recorded and analyzed to identify the location of the fault.

However, it is realized as a part of the present disclosure that conventional systems aiming to use information from the fast transient to locate a fault may need to store a very large number of samples corresponding to a recorded time of milliseconds at a high sample rate, e.g., 300 or 500 kilosamples per second (kS/s), 1 megasample per second (MS/s), or more, so as to preserve the fast transient in memory at the time a fault is detected using level-based techniques.-

Therefore, to substantially reduce the memory or processing requirements for fault-monitoring acquisition boards, while preserving their ability to accurately locate faults, aspects of the present disclosure are directed at enabling the detection of faults directly from the detection of fast transients.

More particularly, according to an aspect of the present disclosure, there is provided a method for monitoring a power line that includes obtaining a signal from the power line, decomposing the signal into one or more frequency bands, and monitoring each frequency band for an indication of a fault on the power line. The signal comprises real-time information corresponding to the current and/or voltage on the power line at a monitoring location, and may be obtained by some measurement means such as a voltage sensor or a current sensor.

By decomposing the signal from the power line into one or more frequency bands, and using these frequency bands to monitor for potential faults on the power line, it is advantageously possible to monitor for particular features in frequency content that would otherwise be too small in amplitude to identify in real time, such as fast transients. Hence, fast transients can be reliably detected in real time, and the detection thereof can be used to trigger a recording of data for subsequent fault location analysis and/or the start of a fault response process.

By identifying the fast transient in the signal from the power line in real time, a fault may be detected well before the (many-fold) rising fault current has reached the monitoring location (that is, before the main current has increased to high enough values to enable conventional protection relays to detect the fault), and hence the recorded data leading up to the detected fault can be substantially reduced while ensuring that the information relating to the fast transient is captured. For example, if, according to the fault detection method disclosed herein, the fault is detected two milliseconds (ms) before a level-based trigger would have triggered, and the acquisition board is sampling at a rate of 500 kS/s, then the memory of the acquisition board can be reduced by an equivalent of 1000 samples.

As will be understood by those skilled in the art, decomposing the signal may comprise performing any sort of splitting or filtering of the frequency content so as to isolate or separate different frequencies in the signal from each other. This thus allows for a higher frequency signal (such as a fast transient) to be clearly identified from an underlying lower frequency signal, such as a 50Hz or 60Hz signal on an AC power line.

That is, decomposing the signal may comprise applying one or more filters to the signal, where the one or more filters is configured to separate the signal into said one or more frequency bands.

In an example, the one or more filters comprise a wavelet filter configured to separate the signal into said one or more frequency bands using a wavelet, and in a preferred example, the wavelet is a Haar wavelet.

Haar wavelet decomposition allows for a computationally efficient analysis of a signal. In essence, a Haar wavelet filter can be constructed as a pair of filters, wherein one is a high-pass filter that takes a difference of adjacent samples and the other is a low-pass filter that averages adjacent samples.

It will be appreciated that other wavelets could be used for the signal analysis, and may be preferred in some cases, e.g., if the computational power of the acquisition board was not limited.

In preferred examples, the signal is decomposed into a plurality of frequency bands, which may be performed in series or in parallel. Put another way, the frequency content of the signal can be monitored at different scales of resolution, which may also be determined by a sampling rate of the acquisition board.

Such an approach of decomposing the signal into a plurality of frequency bands may be especially useful if it is expected that a fast transient fault signal could be stretched or warped by travelling some distance along the power line to the acquisition board, e.g., if the fast transient is first reflected off of an end of the power line on the far side of the fault location. In such cases, the high frequency fast transient signal may appear to have a lower frequency due to the stretching/warping, which may be referred as a 'dispersed signal', and therefore such a warped signal would manifest most prominently at a coarser scale of resolution than an unwarped signal. Put another way, the further a wavefront travels along a power line, the softer the wavefront may be (e.g., a more gentle rise), as higher and lower frequency content in the signal may have different wave speeds and/or attenuation, making them spread out with distance.

Thus, by monitoring a number of different frequency bands, a fast transient fault can be more reliably detected even if it has been stretched or warped. Moreover, a fast transient fault may have a frequency profile that manifests across multiple frequency bands, in which case a detection of a fault in multiple frequency bands can be used to confirm the positive detection of a fault.

The signal may be decomposed into a plurality of frequency bands using a respective plurality of filters forming a cascaded filter bank. For example, a number of Haar wavelet filters may be combined to form a filter bank, such that the outputs of the high-pass and low-pass filters may be downsampled and then again used as inputs to a similar high-pass and low-pass filter, where the output of the subsequent high-pass filter may provide a subsequent frequency band for monitoring that captures frequency content at a coarser scale. This process may be repeated once, twice, or more times, depending on the implementation.

Monitoring a frequency band may comprise comparing information in the frequency band to a threshold indicative of a fault on the power line. For example, if the signal is a plurality of samples representing a scaled proportion of current in a particular frequency band, then each sample may be compared to a threshold which is set as being suggestive of a fast transient fault in the decomposed signal. Detecting a fault on the power line may then be based at least in part on determining that the information in the frequency band exceeds the threshold. Each frequency band may have a respective threshold for the frequency band, indicative of a fault on the power line.

It will be appreciated that monitoring may be performed in some other way, depending on the implementation, but the use of a threshold allows for a relatively straightforward analysis that can be performed at speed and thus may be particularly well suited to real-time analysis.

The threshold for a frequency band may be a static threshold or a dynamic threshold, depending on the implementation. In preferred examples, the threshold is a dynamic threshold based on an exponential moving average, a standard deviation for the frequency band, and/or some other statistical analysis of the present and/or historical information of the frequency band.

By using a dynamic threshold, no complex testing to determine a fixed threshold level may be required, which may be particularly preferable in cases where multiple frequency bands are monitored, and it is unknown how exactly a fast transient may manifest in a particular frequency band. In such cases, treating any sudden deviation from a norm as being a possible fast transient detection may be sufficiently reliable without introducing excessive false positives.

When it is said that a signal on the power line is obtained in 'real-time', it may be meant that the signal is a datastream comprising a plurality of samples obtained as a batch or moving window of one or more samples spanning a time period substantially bounded at one end by a current time. It will be understood that an acquisition board has a degree of latency in sampling voltage or current on the power line, and passing these sampled values for further processing, but in preferred examples, the monitoring for faults is performed based on as up to date information as possible. In some examples, samples obtained from the power line may be processed one at a time.

Obtaining the signal may comprise sampling the current and/or voltage on the power line at the monitoring location at a sampling rate of 250 kilosamples per second, kS/s, to 5000 kS/s, preferably 360 kS/s, thereby to obtain the signal as a datastream. It will be understood that, if a higher sampling rate is used, then a fast transient can be captured in greater detail, and thus a more precise timestamp may be obtained for the fast transient, thereby allowing for a more accurate fault location.

As aspects of the present disclosure allow for a reduced recording time to be stored in a local memory, the sampling rate may be advantageously increased by employing the technique disclosed herein. However, it may be preferred to instead reduce the on-board memory for the acquisition board and use a sampling rate that enables the best trade-off between fidelity and memory usage.

As discussed above, the detection of a fault from the monitoring of a frequency band may trigger, among other things, the storage/recording of data for subsequent processing to determine a fault location. This may, in some examples, comprise the temporary or permanent local or remote storage of the initially obtained signal. In other examples, the plurality of frequency bands may be combined to thereby form a reconstructed signal. The plurality of frequency bands may be combined to form the reconstructed signal in response to the detection of a fault, such that the reconstructed signal comprises a fault signal.

As each frequency band comprises a constituent part of the overall frequency content of the originally obtained signal, the combination of frequency bands may enable the original signal to be reconstructed with sufficient detail to enable accurate fault location. Hence, it may not be required to store the original signal (over the whole recorded time window), thereby freeing up further memory in the acquisition board.

In the particular example where the signal is decomposed into a plurality of frequency bands by a cascaded filter bank of Haar wavelet filters, combining the frequency bands may comprise combining each of the high-pass filter outputs (which capture in them the details associated with each frequency scale) with one or more of the low-pass filter outputs, such as the final low-pass filter output (which captures a low-resolution representation of the original signal). In this way, previous low-pass filter outputs can be discarded from memory after they have been used for creating subsequent frequency bands, thus freeing up further memory on the acquisition board.

A portion of the original signal or the reconstructed signal, which has been stored or recorded in response to a fault such that said portion comprises a fault signal which contains information about the fault, may be processed to reveal the location of the fault. Determining a location of the fault on the power line may be based on a timestamp for the fault signal. The location of the fault may further be determined based on a known or calculated wave speed, in a manner understood by those skilled in the art.

At least a part of the signal may be stored on a local memory, and said at least a part of the local memory may be purged if no fault signal is detected in the part of the signal. In this way, only portions of the signal that contain useful information for locating the fault are preserved in memory and the rest of the memory may be used for continuing a monitoring of the power line.

It may be that the acquisition board is entirely isolated in its operations, or it may be in communication with other acquisition boards or some coordinating device responsible for monitoring the power transmission network. The acquisition board may comprise a local memory such as a RAM (random access memory), flash memory, or the like, for performing real-time computations, and the acquisition board may further comprise an external or hard memory such as an HDD (hard disk drive) or SSD (solid state drive). The external memory may instead be on another remote device that the acquisition board is able to communicate with.

At least a part of the signal, one or more frequency bands, or the reconstructed signal may be sent to such an external memory in response to detecting a fault signal in the part of the signal. The external memory may be used for longer term storage for the purposes of collating fault data, and/or may be configured to provide a separate processing space for processing the fault signal to determine the fault location.

Preferably, data compression is applied to data before storing or sending it between memories, so as to further reduce the amount of memory used on the acquisition board or the amount of bandwidth required to communicate data from the acquisition board. Any suitable data compression may be used. For example, if information in one or more frequency bands comprises a plurality of substantially identical samples in a row (e.g., zeroes), then a special character may be coined for, e.g., 100 identical samples or 1000 identical samples, etc. In an example, an ampersand '&' may be used in place of 1000 zero-value samples, to reduce the amount of space required to store said samples without removing any useful information.

According to a further aspect of the present disclosure, there is provided a device for monitoring a power line of a power transmission network, comprising a memory and a processing device, wherein the memory comprises a set of instructions stored thereon which, when executed by the processing device, cause the processing device to carry out the method substantially as described above.

The device may be or comprise an acquisition board and the instructions may be installed onto the memory as a computer program product. The instructions may further be transmitted or stored on a transitory or non-transitory computer readable medium.

In an example, the device may comprise a microcontroller such as a one chip microcontroller with clock speed up to 0.5 GHz and 1 or more Mbytes of memory.

Devices with similar, better, or worse specifications, in terms of processing power and/ memory may be

used, depending on the implementation.

According to yet a further aspect of the present disclosure, there is provided a power transmission network comprising at least one power line, and one or more devices for monitoring the at least one power line, substantially as described above, installed at respective one or more monitoring locations on the at least one power line.

The devices may be installed at one or both ends of the at least one power line, and may be configured to detect fast transient faults directly and/or reflected off of the other end of the power line to an end nearest the device, depending on the implementation.

Further advantages of the present aspects than those described above may be appreciated by those skilled in the art, and the above-described advantages or further advantages may be made (further) apparent through the following description of one or more embodiments of the present disclosure.

**Brief Description of the Drawings**

One or more embodiments will be described, by way of example only, and with reference to the following figures, in which:

Figures 1A and 1B schematically show fault location techniques carried out by one or more devices arranged on a power line;

Figure 2 schematically shows a fault monitoring device according to aspects of the present disclosure;

Figure 3 schematically shows a fault monitoring process where a power line signal is decomposed into a single monitored frequency band;

Figure 4 schematically shows a fault monitoring process where a signal is decomposed into a plurality of monitored frequency bands;

Figure 5 schematically shows a fault monitoring process where a signal is decomposed into a plurality of monitored frequency bands using a cascaded Haar wavelet filter bank; and

Figure 6 illustrates example input(s) and output(s) from a cascaded Haar wavelet filter bank such as that shown in figure 5.

**Detailed Description**

The present disclosure is described in the following by way of a number of illustrative examples. It will be appreciated that these examples are provided for illustration and explanation only and are not intended to be limiting on the scope of the disclosure.

Furthermore, although the examples may be presented in the form of individual embodiments, it will be recognized that the present disclosure also covers combinations of the embodiments described herein.

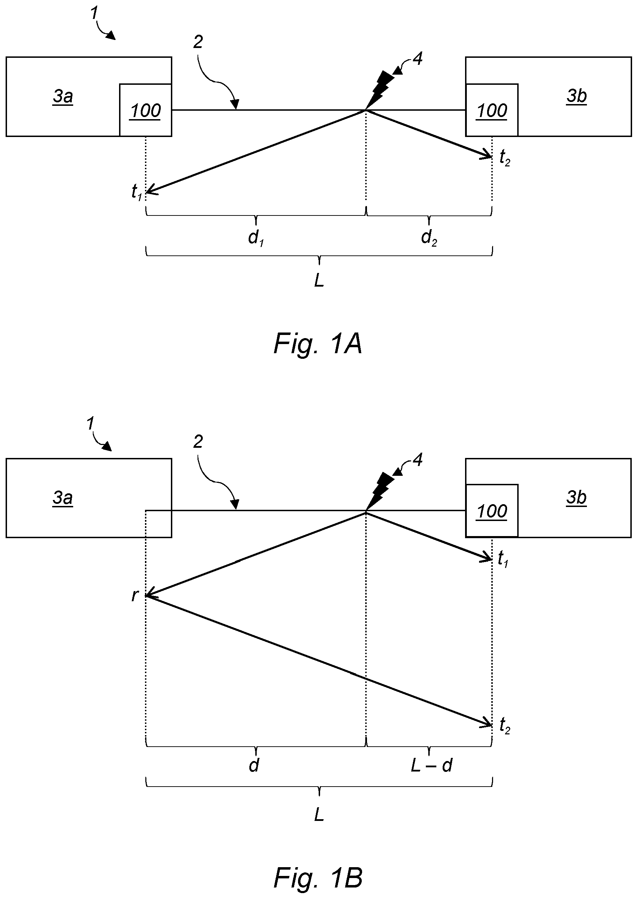

Figure 1A schematically shows a power transmission system 1 comprising a power line 2 connected between two substations 3a and 3b, where the power line has a length L. A fault 4, such as a ground fault, is shown on the power line 2. Installed at each of the substations 3a and 3b is a fault location device 100, which also may be referred to as a fault detection device 100, a fault recording device 100, or simply 'device 100'.

The substations 3a and 3b in this example are arranged at each end of the power line 2. The power line 2 may be supported along its length L, which may be hundreds of kilometers, for example, by a plurality of pylon towers (not shown) or the like.

The fault location device 100 is configured to detect and record faults on the power line 2 such as the fault 4 shown as occurring at a distance $d_1$ from the substation 3a and a distance $d_2$ from substation 3b, where $d_1$ is shown as being longer than $d_2$ in this example. In the event of a fault 4, it is desirable to detect and record information relating to the fault 4 so as to enable an accurate location of the fault 4. The length L of the power line 2 may be kilometers (kms), tens of kms or longer, depending on the implementation, and therefore an accurate location of the fault 4 may help with a more rapid deployment of service teams to inspect or repair the fault 4.

The fault 4 may result in an initial fast transient signal caused by a travelling wave on the power line 2 travelling at a wave speed, $v_w$, followed by a surging fault current on the power line 2. Therefore, traveling wave-based fault localization may use information of when the fast transient from the fault 4 arrives at the devices 100, coupled with a known/estimated wave speed $v_w$.

In the example shown in figure 1A, timestamps $t_1$ and $t_2$ may be determined by the devices 100 on each of the substations 3a and 3b, respectively, and the fault 4 may be located (e.g., by the device at substation 3a, relative to substation 3a), by calculating:

$$d_1 = \frac{1}{2}(L - (t_2 - t_1) \times v_w).$$

This example is representative of a 'double end' method, and the example shown in figure 1B is representative of a 'single end' method, where only one device 100 is shown, and the fault 4 may be located by calculating:

$$d_1 = \frac{1}{2}\big((t_2 - t_1) \times v_w\big).$$

In the single end method shown in figure 1B, the fast transient signal from of the traveling wave may first reflect off of the other end of the power line 2 (at point r shown in figure 1B) before arriving at the device 100 at time $t_2$ after the initial (unreflected, direct) wave arrived at the device 100 at $t_1$.

It will be understood from the above discussion that the precision/accuracy of the determination of the timestamps $t_1$ and $t_2$ has a direct relation to the accuracy of the determined location of the fault 4.

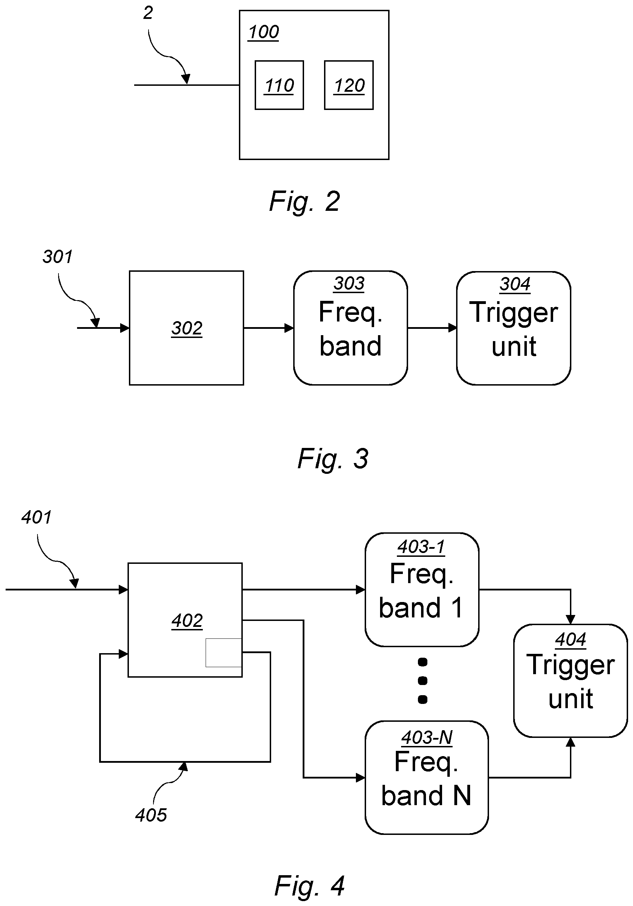

Figure 2 schematically shows a device like the device(s) 100 shown in figures 1A and 1B, according to an example. The device 100 comprises a processor 110 and a memory 120. The device 100 may further comprise sensing electronics such as a voltage and/or current sensor configured to sense a voltage and/or current on the power line 2. The sensing electronics may, for example, sample the voltage and/or current on the power line 2 at some sampling frequency, such as 360 kilosamples per second (kS/s).

Generally speaking, the device may operate by carrying out, with the processor, 110, computer-readable instructions which may be stored in the memory 120, in a manner understood by those skilled in the art. Put another way, the device 100 may generally be configured as a computing device such as an acquisition board.

Especially in a large transmission system having a large number of devices such as the device 100, it may be desired to minimize the required processing power of the processor 110 and/or the capacity of the memory 120, without compromising the accuracy of the fault timestamps determined by the device 100. However, if a large number of samples of the voltage and/or current are obtained every second, the memory 120 may be quickly filled.

It will be understood that, to determine the timestamp for a fault, the fault must first be detected such that the associated data can be recorded and processed. That is, it will be understood that information relating to the fault may be received by the device 100 before the fault has been actually detected. Therefore, once the fault is detected, the data relating to the fault will have already been received, where the first indication of the fault may be the fast transient resulting from the travelling wave from the fault.

As accurate fault location benefits from an accurate timestamping of this fast transient signal, it is desirable that the fast transient signal is well recorded in the memory 120 of the device 100 at the time the fault is actually detected.

If fault detection is carried out using level-based methods, wherein a current or voltage threshold level is set so that the surging fault current triggers the fault detection, this surging fault current may occur a long time after the arrival of the fast transient signal, such as a number of milliseconds (ms), such as 5 ms or more, after the arrival of the fast transient signal. Hence, to ensure that information relating to the fast transient is still in the memory 120, the memory 120 may be sized to accommodate samples from 10 ms of sampling or more.

However, at very high sampling rates, which are desirable for precise recordings of the fast transients, 10 ms of sampling time may result in a large number of samples and hence the memory 120 needs to be correspondingly large.

Aspects of the present disclosure are aimed at detecting the occurrence of a fault by detecting the fast transient signal itself, such that the size of the memory 120 can be reduced and/or the sampling rate of the device 100 can be increased. In this way, the only delay between the arrival of the fast transient signal and the detection of a fault is the time required for the fault detection to take place, without a further delay owing to subsequent arrival of the surging fault current.

Figure 3 schematically shows an example implementation of a fault monitoring scheme according to aspects of the present disclosure.

A signal 301 is obtained from a power line, where the signal 301 may be formed as, for example, a datastream having a plurality of samples, having some sampling rate. Preferably, the sampling rate is as high as possible to improve the detail captured in the signal 301. Hence, the signal 301 may comprise real-time information corresponding to the current and/or voltage on the power line at a monitoring location (i.e., where the device is installed, such as at a substation).

The signal 301 is decomposed by a decomposition unit 302 into a frequency band 303. The decomposition may comprise one or more filters such as a bandpass filter, high-pass filter, low-pass filter, and may be implemented through digital or analogue means, depending on the implementation.

The frequency band 303 may comprise a subset of the frequency content from the signal 301, such as only high-frequency content, with the underlying lower frequency content (e.g., a 50 Hz or 60 Hz carrier wave) filtered out.

In this way, fault signals such as fast transients, which often have frequencies substantially removed from the main frequency on the power line, can be isolated from the rest of the signal(s) on the power line. This is particularly beneficial when considering the relatively low magnitude of a fast transient fault signal relative to the main/dominant signal 301 on the power line, which may manifest as a ripple of 1% or less of the main signal 301.

Thus, the frequency band 303 may be monitored for an indication of a fault on the power line, e.g., using a trigger unit 304. The trigger unit 304 may, for example, monitor the frequency band 303 for a sudden and/or high (or higher than normal) level, which may be caused by an increase in a signal at a frequency corresponding to the frequency band. For example, a sudden high-frequency signal, albeit with a low magnitude relative to the main signal 301, may manifest as a spike or surge in the frequency band 303 which can be readily detected in the frequency band 303 and may thus lead the trigger unit 304 to identify an indication of a fault on the power line.

The trigger unit 304 may apply a threshold, in some examples. That is, monitoring the frequency band 303 may comprise comparing information in the frequency band 303 to a threshold indicative of a fault on the power line. Detecting a fault on the power line may be based at least in part on determining that the information in the frequency band exceeds the threshold.

In response to an indication of a fault, data stored in the memory of the device may be recorded and analyzed so as to isolate the fault signal, e.g., the fast transient signal, and derive a fault location therefrom, as discussed above.

Figure 4 shows another example implementation of the presently disclosed fault monitoring techniques, wherein a difference relative to the example shown in figure 3 is at least that a signal 401 is decomposed into a plurality of frequency bands 403-1, ..., 403-N.

As with the example shown in figure 3, the signal 401 may be provided to a decomposition unit 402, which may decompose the signal 401 into a plurality of frequency bands 403-1, ..., 403-N, which may be two frequency bands, three frequency bands, or more, depending on the implementation.

The decomposition unit 402 may comprise one or more filters, where the same one or more filters may decompose the signal 401 into some or all of the plurality of frequency bands 403-1, ..., 403-N, e.g., in parallel. Additionally or alternatively, the same one or more filters, for some or all of the plurality of frequency bands 403-1, ..., 403-N, may be used to re-process an output of the decomposition unit 402 to thereby generate subsequent frequency bands, as indicated by the arrow 405. As yet a further addition or alternative, respective one or more filters may be used to decompose the signal 401 into each of some or all of the plurality of frequency bands 403-1, ..., 403-N.

The plurality of frequency bands 403-1, ..., 403-N may thus each contain information relating to a different frequency content of the signal 401, although some frequency bands 403-1, ..., 403-N may overlap. In the illustrated example, all of the plurality of frequency bands 403-1, ..., 403-N are monitored for an indication of a fault on the power line, using a trigger unit 404. As with the trigger unit 304 shown in figure 3, the trigger unit 404 may apply a threshold, in some examples. That is, monitoring the frequency bands 403-1, ..., 403-N may comprise comparing information in each of the frequency bands 403-1, ..., 403-N to a threshold indicative of a fault on the power line. Detecting a fault on the power line may be based at least in part on determining that the information in the frequency band exceeds the threshold. The threshold for each of the frequency bands may be different, and/or the threshold may be a static threshold or a dynamic threshold, depending on the implementation. For example, the threshold may be a dynamic threshold based on an exponential moving average, a standard deviation for a particular frequency band 403-1, ..., 403-N, and/or some other statistical index.

In an example, the decomposition unit 402 may comprise a cascaded filter bank, and each of the frequency bands 403-1, ..., 403-N may represent frequency content from the signal 401 at an increasingly coarse level (i.e., from 403-1 to 403-N), which may be achieved by re-processing the output of one or more filters in the decomposition unit 402 with the same or another filter of the one or more filters in the decomposition unit 402.

By analyzing the signal 401 at different resolutions/levels of coarseness, a range of frequencies may be monitored, thereby allowing for the possibility that, for example, a high-frequency fast transient signal has become dispersed to an apparently lower frequency by travelling a long distance along the power line (e.g., after reflecting off the other end). Hence, a fault may be more reliably detected and recorded even if the signal indicating the fault has been degraded, by configuring a plurality of different frequency bands 403-1, ..., 403-N.

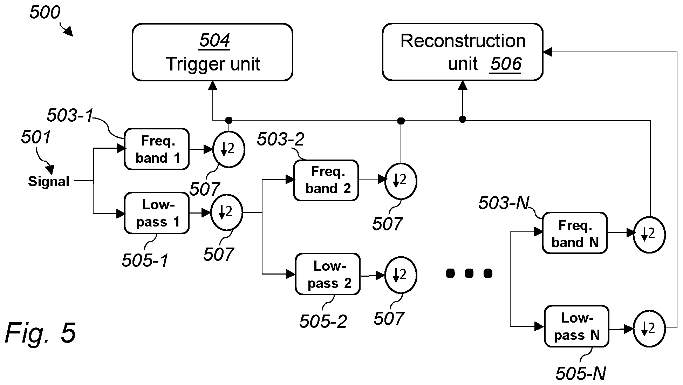

Figure 5 schematically shows, in a flow-chart-like form, a more specific example implementation of a fault monitoring system 500 according to aspects of the present disclosure.

Specifically, figure 5 illustrates a decomposition of a signal 501 into a plurality of different frequency bands 503-1, 503-2, ..., 503-N, using a cascaded filter bank applying a Haar wavelet filter.

A Haar wavelet filter may operate by applying a high-pass filter and a low-pass filter to a signal. In practice, such as when dealing with a signal formed as a datastream having a time-series of samples, the signal may be processed to determine a 'difference' between adjacent samples and a 'sum' of adjacent samples (allowing for some scalar factors).

The 'difference' is, in effect, a high-pass filter that captures the details at a particular scale, and thus captures information relating to frequency content at a frequency corresponding to the sampling rate.

The 'sum' is, in effect, a low-pass filter that averages the signal and thereby forming an approximation of the original signal.

It will be understood that the outputs of the 'difference' and 'sum' are effectively downsampled by 2, which may be represented symbolically as 12, meaning that the outputs may have half as many samples as the inputs, as a result of summing and subtracting of the pairs of adjacent samples in the level above. The process then begins again on the downsampled output signals. It will be understood that the 'difference' taken between adjacent samples in this downsampled output signal represent frequency content at double the scale of the previous 'difference', and the 'sum' outputs an even coarser approximation of the original signal.

This process may thus be repeated multiple times, optionally using the same high-pass 'difference' filters and low-pass 'sum' filters in a loop, so as to decompose the signal and thereby analyse the signal at a number of increasingly coarse scales. The different outputs of the high-pass 'difference' filters may thus be used as representing frequency content from the signal at increasingly coarse scales, and hence, these outputs may be used as frequency bands as discussed above.

As shown in figure 5, a signal 501 is provided to a Haar wavelet filter comprising a low-pass filter 505-1 and a high-pass filter 503-1, wherein the output of the high-pass filter 503-1 is taken as a first frequency band and passed to a trigger unit 504, which may be substantially similar to the trigger unit 304 shown in figure 3 or the trigger unit 404 shown in figure 4.

The outputs of the first high-pass filter 503-1 and the low-pass filter 505-1 are effectively downsampled, as indicated by the block 507. The downsampled 507 output of the first low-pass filter 505-1 is then passed to a next Haar wavelet filter, comprising a second high-pass filter 503-2, providing a second frequency band, and a second low-pass filter 505-2, the outputs of which are, in effect, further downsampled 507 to provide input to the next stage of the cascading filter bank.

This process may repeat any number of times until a final high-pass filter 503-N and low-pass filter 505-N are reached.

The system 500 further comprises a reconstruction unit 506, configured to reconstruct the signal 501 or an approximation thereof in the event that an indication of a fault is detected by the trigger unit 504. In such an event, the output of the final low-pass filter 505-N is combined with a plurality, preferably all, of the frequency bands 503-1, 503-2, ..., 503-N.

The low-pass filter 505-N captures a rough approximation of the signal 501, and the frequency bands 503-1, 503-2, ..., 503-N contain information of details at varying levels of coarseness. Therefore, at least a good approximation of the signal 501 can be obtained through the combination of these sub-signals. It will be appreciated that, if the subsignals are not compressed, then the reconstruction may be exact.

Therefore, it will be understood that the original signal 501 may not need to be saved or recorded, at least not in its entirety, as it may be reconstructed with sufficient fidelity by the reconstruction unit. Accordingly, the amount of memory required in a device implementing this method can be further reduced (e.g., by using compression).

Haar wavelet filters are also highly computationally efficient, and thus the load on a processor on such a device can be advantageously reduced.

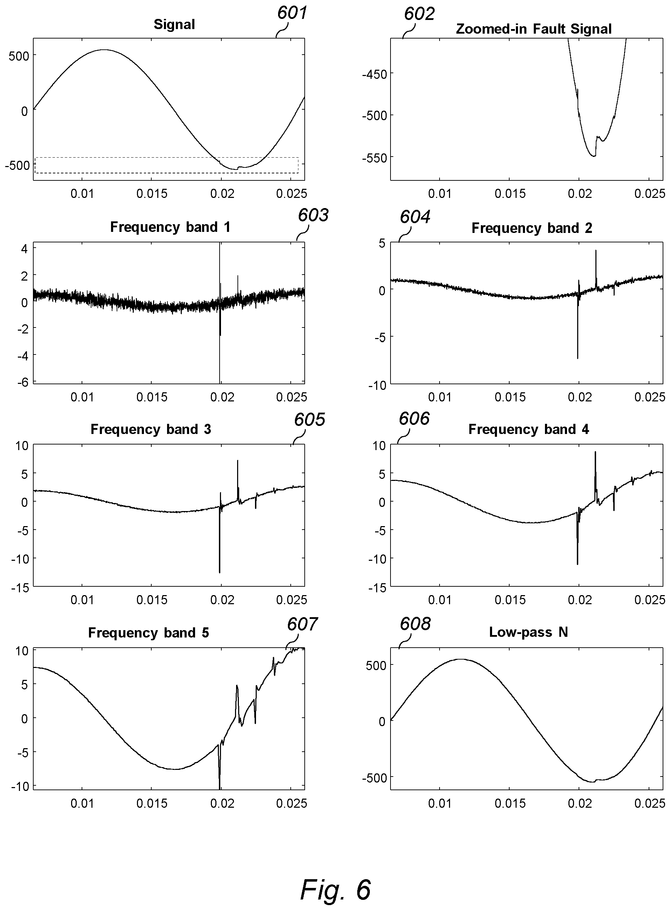

Figure 6 shows example illustrations of signals processed by the cascaded filter bank system 500 shown in figure 5. The plot 601 shows the signal 501, and the plot 602 shows a zoomed in portion thereof (corresponding to the dotted box in the plot 601), illustrating the relatively low magnitude of the fast transient fault signal relative to the primary carrier signal.

Plot 603 shows the frequency band 503-1, and it can be clearly seen that a spike is formed at approximately 0.02 on the arbitrary time scale shared by all plots 601, 602, 603, 604, 605, 606, 607, and 608. It will be understood that such a spike may lead the trigger unit 504 to detect an indication of a fault by exceeding some threshold, e.g., relative to the preceding noisy signal.

Plot 604 shows the frequency band 503-2, representing captured frequency content at a coarser scale than frequency band 503-1 shown in plot 603. A spike is also clearly shown in this plot 604. Hence, it can be seen that an indication of a fault can also be detected by the trigger unit 504 from the second frequency band 503-2. There is also a clearer second spike in 604 - 607, as this spike is relatively much smaller in 603, this spike has a lower frequency content and is thus a reflected wave.

Plots 605, 606, and 607 show further frequency bands at increasing levels of coarseness, i.e., representing longer-wavelength frequency content from the signal 501. As spikes are shown in each of these plots 605, 606, and 607, it will be understood that a condition to remove false positives may be that an indication of a fault is detected in more than one frequency band.

Plot 608 shows the output of the final low-pass filter 505-N, and thus shows a rough approximation of the original signal 501 shown in plot 601. With consideration of the vertical scales of each of the plots 603, 604, 605, 606, and 607, it can be seen that a combination of this rough approximation shown in plot 608 with each of the frequency bands can produce a substantially accurate reconstruction of the original signal 501 shown in plot 601.

Aspects of the present disclosure may be better understood through appreciation of the following numbered clauses:

1. A method for monitoring a power line, comprising:

obtaining a signal from the power line, comprising real-time information corresponding to the current and/or voltage on the power line at a monitoring location;
decomposing the signal into one or more frequency bands; and monitoring each frequency band for an indication of a fault on the power line.

2. The method according to clause 1, wherein decomposing the signal comprises applying one or more filters to the signal, the one or more filters being configured to separate the signal into said one or more frequency bands.

3. The method according to clause 2, wherein the one or more filters comprise a wavelet filter configured to separate the signal into said one or more frequency bands using a wavelet.

4. The method according to clause 3, wherein the wavelet is a Haar wavelet.

5. The method according to any preceding clause, comprising decomposing the signal into a plurality of frequency bands.

6. The method according to clause 5, wherein the signal is decomposed into a plurality of frequency bands using a respective plurality of filters forming a cascaded filter bank.

7. The method according to any preceding clause, wherein monitoring a frequency band comprises comparing information in the frequency band to a threshold indicative of a fault on the power line.

8. The method according to clause 7, further comprising detecting a fault on the power line based at least in part on determining that the information in the frequency band exceeds the threshold.

9. The method according to any of clauses 5 to 8, wherein monitoring the plurality of frequency bands comprises comparing information in each frequency band to a respective threshold for the frequency band, indicative of a fault on the power line.

10. The method according to any of clauses 7 to 9, wherein the threshold for each frequency band is a static threshold or a dynamic threshold.

11. The method according to clause 10, wherein the threshold is a dynamic threshold based on an exponential moving average and/or a standard deviation for the frequency band.

12. The method according to any preceding clause, wherein the signal is a datastream comprising a plurality of samples obtained as a batch or moving window of one or more samples spanning a time period substantially bounded at one end by a current time.

13. The method according to any preceding clause, further comprising sampling the current and/or voltage on the power line at the monitoring location at a sampling rate of 250 kilosamples per second, kS/s, to 5000 kS/s, preferably 360 kS/s, thereby to obtain the signal as a datastream.

14. The method according to any of clauses 5 to 13, further comprising combining the plurality of frequency bands to thereby form a reconstructed signal.

15. The method according to clause 14, wherein the plurality of frequency bands are combined to form the reconstructed signal in response to the detection of a fault, such that the reconstructed signal comprises a fault signal.

16. The method according to clause 15, further comprising determining a location of the fault on the power line based on a timestamp for the fault signal.

17. The method according to any preceding clause, wherein at least a part of the signal is stored on a local memory, and further comprising purging said at least a part of the local memory if no fault signal is detected in the part of the signal.

18. The method according to any preceding clause, further comprising sending at least a part of the signal, one or more frequency bands, or the reconstructed signal to an external memory in response to detecting a fault signal in the part of the signal.

19. The method according to any preceding clause, further comprising applying a data compression to the one or more frequency bands.

20. A device for monitoring a power line of a power transmission network, comprising:

    a memory; and
    a processing device;
    wherein the memory comprises a set of instructions stored thereon which, when executed by the processing device, cause the processing device to carry out the method according to any preceding clause.

21. A power transmission network comprising:

    at least one power line; and
    one or more devices for monitoring the at least one power line, according to clause 20, installed at respective one or more monitoring locations on the at least one power line.

Whilst the present disclosure is susceptible to various modifications and alternative forms, specific embodiments are shown and described above by way of example in relation to the drawings, with a view to clearly explaining the various advantageous aspects of the present disclosure. It should be understood, however, that the detailed description herein and the drawings attached hereto are not intended to limit the disclosure to the particular form disclosed. Rather, the intention is to cover all modifications, equivalents, and alternatives falling within the scope of the following claims.

**Claims**

1.   A method for monitoring a power line, comprising:

    obtaining a signal (301) from the power line, comprising real-time information corresponding to the current and/or voltage on the power line at a monitoring location;
    decomposing the signal into one or more frequency bands (303); and
    monitoring each frequency band (303) for an indication of a fault on the power line.

**2.** The method according to claim 1, wherein decomposing the signal comprises applying one or more filters to the signal, the one or more filters being configured to separate the signal into said one or more frequency bands.

**3.** The method according to claim 2, wherein the one or more filters comprise a wavelet filter configured to separate the signal into said one or more frequency bands using a wavelet.

**4.** The method according to claim 3, wherein the wavelet is a Haar wavelet.

**5.** The method according to any preceding claim, comprising decomposing the signal into a plurality of frequency bands.

**6.** The method according to claim 5, wherein the signal is decomposed into a plurality of frequency bands using a respective plurality of filters forming a cascaded filter bank.

**7.** The method according to any preceding claim, wherein monitoring a frequency band comprises comparing information in the frequency band to a threshold indicative of a fault on the power line.

**8.** The method according to any of claims 5 to 7, wherein monitoring the plurality of frequency bands comprises comparing information in each frequency band to a respective threshold for the frequency band, indicative of a fault on the power line.

**9.** The method according to any of claims 6 to 8, wherein the threshold for each frequency band is a static threshold or a dynamic threshold.

**10.** The method according to any preceding claim, wherein the signal is a datastream comprising a plurality of samples obtained as a batch or moving window of one or more samples spanning a time period substantially bounded at one end by a current time.

**11.** The method according to any of claims 5 to 10, further comprising combining the plurality of frequency bands to thereby form a reconstructed signal.

**12.** The method according to claim 11, wherein the plurality of frequency bands are combined to form the reconstructed signal in response to the detection of a fault, such that the reconstructed signal comprises a fault signal.

**13.** The method according to any preceding claim, wherein at least a part of the signal is stored on a local memory, and further comprising purging said at least a part of the local memory if no fault signal is detected in the part of the signal.

**14.** A device (100) for monitoring a power line (2) of a power transmission network (1), comprising:

a memory (120); and
a processing device (110);
wherein the memory (120) comprises a set of instructions stored thereon which, when executed by the processing device (110), cause the processing device (110) to carry out the method according to any preceding claim.

**15.** A power transmission network (1) comprising:

at least one power line (2); and
one or more devices (100) for monitoring the at least one power line (2), according to claim 14, installed at respective one or more monitoring locations on the at least one power line (2).

Fig. 1A

Fig. 1B

*Fig. 2*

*Fig. 3*

*Fig. 4*

*Fig. 6*

Fig. 5

Europäisches
Patentamt
European
Patent Office
Office européen
des brevets

# EUROPEAN SEARCH REPORT

**Application Number**

EP 24 16 3650

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/085574 A1 (PAN YAN [US] ET AL) 2 April 2009 (2009-04-02) | 1-3,5,6, 11,12, 14,15 | INV. G01R19/25 G01R31/08 |
| A | * paragraphs [0049], [0050]; claim 1; figure 4 * | 13 | |
| X | XU WENKANG ET AL: "Extraction of Fault Characteristic Frequency Band of Photovoltaic DC Series Arc Based on Wavelet Packet Transform and Tsallis Entropy", 2023 5TH ASIA ENERGY AND ELECTRICAL ENGINEERING SYMPOSIUM (AEEES), IEEE, 23 March 2023 (2023-03-23), pages 551-558, XP034338995, DOI: 10.1109/AEEES56888.2023.10114208 [retrieved on 2023-05-08] | 1-9,11, 12,14,15 | |
| A | * paragraphs [IIIC], [IIIB] * | 13 | |
| X | CN 110 677 125 B (QINHUANGDAO POWER SUPPLY CO OF STATE GRID JIBEI ELECTRIC POWER CO LTD) 1 July 2022 (2022-07-01) | 1-3,5,6, 10-12, 14,15 | **TECHNICAL FIELDS SEARCHED (IPC)** |
| A | * summary and; pages 9-11 * | 13 | G01R |
| X | CN 112 924 810 B (ZIBO POWER SUPPLY CO STATE GRID SHANDONG ELECTRIC POWER CO ET AL.) 17 June 2022 (2022-06-17) | 1-3,5-9, 11,12, 14,15 | |
| A | * pages 8-10; claim 1 * | 13 | |
| X | US 2020/403406 A1 (SHAFIULLAH MD [SA] ET AL) 24 December 2020 (2020-12-24) * paragraph [0069] * | 1,14 | |
| A | US 5 848 365 A (COVERDILL CARY N [US]) 8 December 1998 (1998-12-08) * column 6, line 40 - line 49 * | 1-15 | |

The present search report has been drawn up for all claims

| Place of search | Date of completion of the search | Examiner |
|---|---|---|
| The Hague | 24 July 2024 | Reeb, Bertrand |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 16 3650

This annex lists the patent family members relating to the patent documents cited in  the above-mentioned European search report.
The members are as contained in the European Patent Office EDP file on
The European Patent Office is in no way liable for these particulars which are merely given for the purpose of information.

24-07-2024

| Patent document cited in search report | Publication date | Patent family member(s) | Publication date |
|---|---|---|---|
| US 2009085574 A1 | 02-04-2009 | NONE | |
| CN 110677125 B | 01-07-2022 | NONE | |
| CN 112924810 B | 17-06-2022 | NONE | |
| US 2020403406 A1 | 24-12-2020 | NONE | |
| US 5848365 A | 08-12-1998 | NONE | |

EPO FORM P0459

For more details about this annex : see Official Journal of the European Patent Office, No. 12/82